Europäisches Patentamt

European Patent Office

Office européen des brevets

(19)

(11) **EP 0 545 256 B1**

(12) **EUROPÄISCHE PATENTSCHRIFT**

(45) Veröffentlichungstag und Bekanntmachung des Hinweises auf die Patenterteilung:
**10.09.1997 Patentblatt 1997/37**

(51) Int Cl.⁶: **H01L 27/108**, H01L 23/528

(21) Anmeldenummer: **92120086.1**

(22) Anmeldetag: **25.11.1992**

(54) **Bitleitungsanordnung für integrierte Schaltungen**

Arrangement of bitlines for integrated circuits

Configuration de lignes de bit pour des circuits intégrés

(84) Benannte Vertragsstaaten:
**AT DE FR GB IE IT NL**

(30) Priorität: **02.12.1991 DE 4139719**

(43) Veröffentlichungstag der Anmeldung:
**09.06.1993 Patentblatt 1993/23**

(73) Patentinhaber: **SIEMENS AKTIENGESELLSCHAFT
80333 München (DE)**

(72) Erfinder: **Melzner, Hanno, Dipl.-Phys.
Wappingers Falls, NY 12590 (US)**

(56) Entgegenhaltungen:
**EP-A- 0 399 531        EP-A- 0 428 247**

- **PATENT ABSTRACTS OF JAPAN vol. 15, no. 514 (E-1150)27. Dezember 1991**
- **PATENT ABSTRACTS OF JAPAN vol. 15, no. 62 (E-1033)14. Februar 1991**
- **PATENT ABSTRACTS OF JAPAN vol. 14, no. 263 (E-938)(4206) 7. Juni 1990**

**Beschreibung**

Die Erfindung betrifft eine Bitleitungsanordnung für integrierte Schaltungen, wobei jede Bitleitung mindestens einen Kontakt zu einem unterliegenden leitfähigen Gebiet besitzt, nur in einer Umgebung des Kontaktes zu einer Kontaktfläche verbreitert ist und die Kontakte benachbarter Bitleitungen versetzt unter Bildung einer mindestens 3-fachen Staffelung angeordnet sind.

Bei integrierten Schaltungen, insbesondere DRAM-Halbleiter-Speichern, werden die (Speicher-)Zellen mit Bitleitungen kontaktiert, wobei eine Bitleitung einen Zugriff auf eine Reihe von Zellen ermöglicht. Die vorgegebene Anordnung der Zellen bestimmt daher die Anordnung dieser Kontakte; dabei kann entweder jede Zelle einen eigenen Kontakt zur überliegenden Bitleitung besitzen, oder es werden zwei benachbarte Zellen über einen Kontakt an die Bitleitung angeschlossen. Entsprechend beträgt der Abstand zwischen zwei aufeinanderfolgenden Kontakte derselben Bitleitung eine oder zwei Zelllängen. In der Umgebung der Kontakte ist es sowohl aus verfahrenstechnischen als auch aus elektrischen Gründen im allgemeinen notwendig, die Bitleitung zu einer Kontaktfläche zu verbreitern. Andererseits wird ein minimaler Platzbedarf angestrebt.

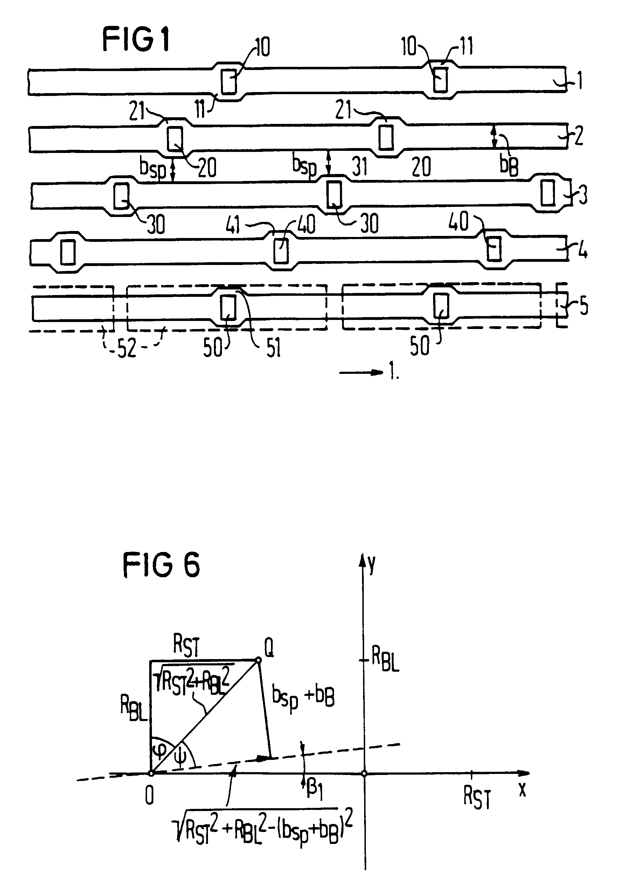

In Figur 1 ist schematisch eine dem Stand der Technik entsprechende Bitleitungsanordnung dargestellt. Die Bitleitungen 1, 2, 3, 4, 5 verlaufen in einer ersten Richtung, welche durch die geradlinige Verbindung zwischen Kontakten derselben Bitleitung definiert ist, über (nur bei der Bitleitung 5 dargestellte) Zellen 52 und weisen Kontakte 10, 20, 30, 40, 50 auf, über die sie jeweils mit einer oder zwei der Zellen verbunden sind. In einer Umgebung der Kontakte sind die Bitleitungen zu Kontaktflächen 11, 21, 31, 41, 51 verbreitert, um auch bei einer Dejustierung der Bitleitungen gegenüber den Kontakten (die im allgemeinen durch Kontaktlöcher in einer unterliegenden Isolationsschicht realisiert sind) eine ausreichende elektrische Verbindung zu gewährleisten. Die Abstände zwischen benachbarten Bitleitungen bzw. ihren Kanten kann insbesondere aus prozesstechnischen Gründen (Auflösungsvermögen bei der fototechnischen Strukturierung der Bitleitungen) einen gewissen Minimalwert $b_{Sp}$ nicht unterschreiten. Minimalabstand liegt zwischen einer Kontaktfläche und der benachbarten Bitleitungs-Kante vor (siehe Figur 1; die Kontakte sind dabei in einer 4-fachen Staffelung angeordnet). Bei einer solchen konventionellen Anordnung kann bei vorgegebenem Minimalabstand $b_{Sp}$ der Platzbedarf nicht weiter verringert werden, ohne die Kontaktfläche oder die Breiten $b_B$ der Bitleitung außerhalb der Kontaktfläche zu verkleinern und damit die Zuverlässigkeit zu erniedrigen.

In EP-A-0 399 531 ist ein Halbleiterspeicher mit einer gattungsbildenden Bitleitungsanordnung beschrieben. Der Minimalabstand zwischen benachbarten Bitleitungen tritt in der Umgebung der Kontaktfläche auf. In EP-A-0 428 247 ist ebenfalls eine Bitleitungsanordnung offenbart, bei der der Minimalabstand nur zwischen einer Kontaktfläche und der benachbarten Bitleitungskante vorliegt.

Aufgabe der vorliegenden Erfindung ist es daher, eine Bitleitungsanordnung anzugeben, die bei gleichem oder verringertem Platzbedarf eine größere oder mindestens gleich große Zuverlässigkeit aufweist.

Diese Aufgabe wird dadurch gelöst, daß der Abstand zwischen den Kanten zweier benachbarter Bitleitungen (im Rahmen von Herstellungstoleranzen) überall gleich groß ist, d. h., daß der Minimalabstand $b_{Sp}$ nicht nur zwischen Bitleitungs-Kanten außerhalb der Kontaktflächen auftritt. Hierdurch kann entweder die Kontaktfläche vergrößert werden oder bei gleich großer Kontaktfläche ein Platzgewinn erzielt werden. Bei einer Vergrößerung der Kontaktfläche wird nicht nur die maximal zulässige Dejustierung der Bitleitungen gegenüber den erwähnten Kontaktlöchern größer, sondern auch der Strompfad um das Kontaktloch herum breiter. Im Kontaktloch ist üblicherweise die Schichtdicke des Bitleitungsmaterials gering, sodaß ein breiter Überlapp hilfreich ist, um niedrige Bitleitungswiderstände zu erzielen.

Die Erfindung wird nachfolgend anhand zweier in den Zeichnungen dargestellten Ausführungsbeispiele näher beschrieben. Es zeigen:

Figur 1 einen Ausschnitt einer dem Stand der Technik entsprechenden Bitleitungsanordnung,

Figuren 2 und 4 jeweils einen Ausschnitt zweier Ausführungsformen der erfindungsgemäßen Bitleitungsanordnung.

Figuren 3 und 5 erläutern in vergrößerter Darstellung das Konstruktionsprinzip für die Ausführungsbeispiele.

Figur 6 ist eine Skizze zur Berechnung der die Bitleitungskanten beschreibenden Geraden.

In allen Figuren sind gleiche Teile mit gleichen Bezugszeichen versehen.

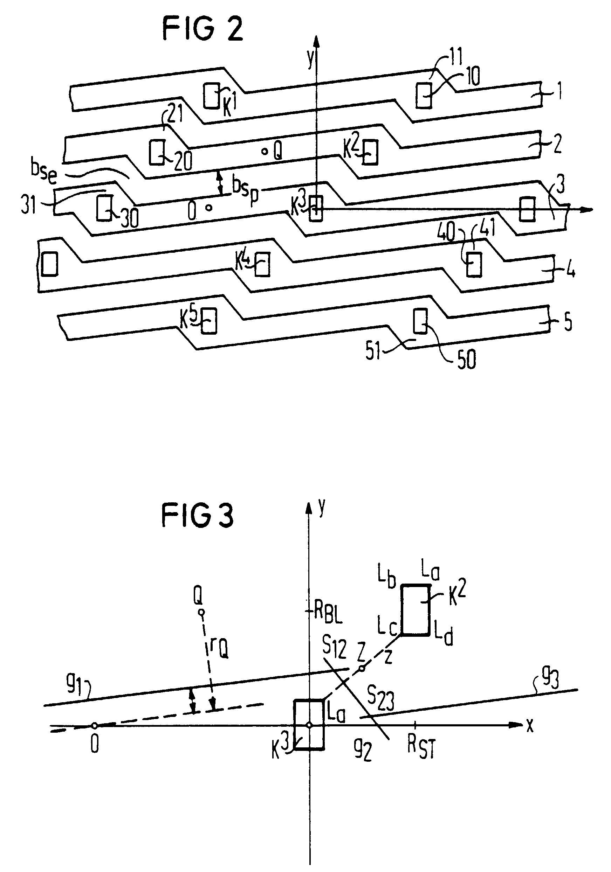

Figur 2: Die geometrische Anordnung der Kontakte 10, 20, 30, 40, 50 entspricht der in Figur 1 und wird beispielsweise durch die unterliegende Zellenanordnung vorgegeben; ebenso besitzen die Kontakte dieselbe Größe wie in Figur 1. Erfindungsgemäß ist der Abstand zwischen den Kanten benachbarter Bitleitungen überall gleich groß, insbesondere gleich dem Minimalabstand $b_{Sp}$, auch im Bereich außerhalb der Kontaktflächen 11, 21, 31, 41, 51. In dieser Ausführungsform werden die Kanten der Bitleitungen 1 bis 5 abschnittsweise von Geraden gebildet, die nicht parallel zur ersten Richtung verlaufen. Dabei treten Geraden mit genau zwei verschiedenen Steigungen auf.

Zur weiteren Erläuterung, auch für die folgenden Figuren, wird ein Koordinatensystem eingeführt mit der x-Achse parallel zur ersten Richtung, der y-Achse senkrecht zur ersten Richtung und dem Ursprung im Mittelpunkt des Kon-

taktes $K^3$ der Bitleitung 3, wie der Figur 2 zu entnehmen ist. Ferner wird definiert:

$b_B$: Breite einer Bitleitungs-Bahn, d.h. einer Bitleitung außerhalb einer Kontaktfläche
$b_{Sp}$: Abstand zwischen den Kanten benachbarter Bitleitungen
$R_{BL}$: Bitleitungs-Raster in y-Richtung
$R_{St}$: Staffelungsraster = Versatz der Kontakte benachbarter Bitleitungen in x-Richtung
n: Staffelung, in den Ausführungsbeispielen ist n=4
$K^1$ - $K^5$: Bezeichnet die n+1 in der Zeichnung angegebenen Kontakte
$L^i_a$ - $L^i_d$: Bezeichnet die Eckpunkte der Kontakte $K^i$, i=1,..n+1

Figur 3: Die Konstruktion der Bitleitungsanordnung von Figur 2 erfolgt mit Hilfe dreier Geraden $g_1$, $g_2$, $g_3$, die abschnittsweise die Bitleitungs-Kanten darstellen. Die Konstruktion dieser Geraden wird im folgenden am Beispiel der Bitleitung 3 und der Kontakte $K^3$, $K^2$ erläutert (siehe auch Figur 2):

$g_1$: - Mittelpunkt 0 der Verbindungsstrecke zwischen $K^3$ und dem in -x-Richtung benachbarten Kontakt der Bitleitung 3, 0 hat die Koordination 0 (-2 $R_{St}$; 0)
- Mittelpunkt Q der Verbindungsstrecke zwischen $K^2$ und dem in -x-Richtung benachbarten Kontakt der Bitleitung 2, Q (-$R_{St}$; $R_{BL}$)
- Kreis $k_Q$ um Q mit Radius $r_Q = b_B + b_{Sp}$
- Tangente an Kreis $k_Q$ durch 0; diese Tangente ist die Bahnachse (Mittellinie) des gesuchten Bitleitungs-Abschnitts
- $g_1$ ist Parallele zur Bahnachse im Abstand 1/2 $b_B$.

$g_2$: - Verbindungsstrecke z zwischen $L^3_a$ und $L^2_c$ mit Mittelpunkt Z
- $g_2$ ist senkrecht auf z im Abstand 1/2 $b_{Sp}$ von Z.

$g_3$: - $g_3$ entsteht durch Translation von $g_1$ in +x-Richtung um $4R_{St}$.

Wie in der Figur erkennbar ist, schneiden sich die Geraden in den Punkten $S_{12}$ bzw. $S_{23}$ und bilden in den entsprechenden Abschnitten die eine Kante der Bitleitung 3. Die andere Kante und die Kanten der übrigen Bitleitungen sowie ihre Fortsetzungen in +x- und -x-Richtung erhält man in einfacher Weise durch Punktspiegelung am Ursprung und Translationen aus diesen Geraden.

Die Verallgemeinerung auf eine n-fache Staffelung ist einfach möglich: Beispielsweise lauten die Koordinaten des Mittelpunktes 0 (-$\frac{n}{2} R_{St}$;0) ; 0 ist gleichzeitig Mittelpunkt von $K^1$ und $K^{n+1}$, falls n gerade ist. $g_3$ erhält man durch eine Translation um $nR_{St}$. $g_2$ wird wie beschrieben konstruiert.

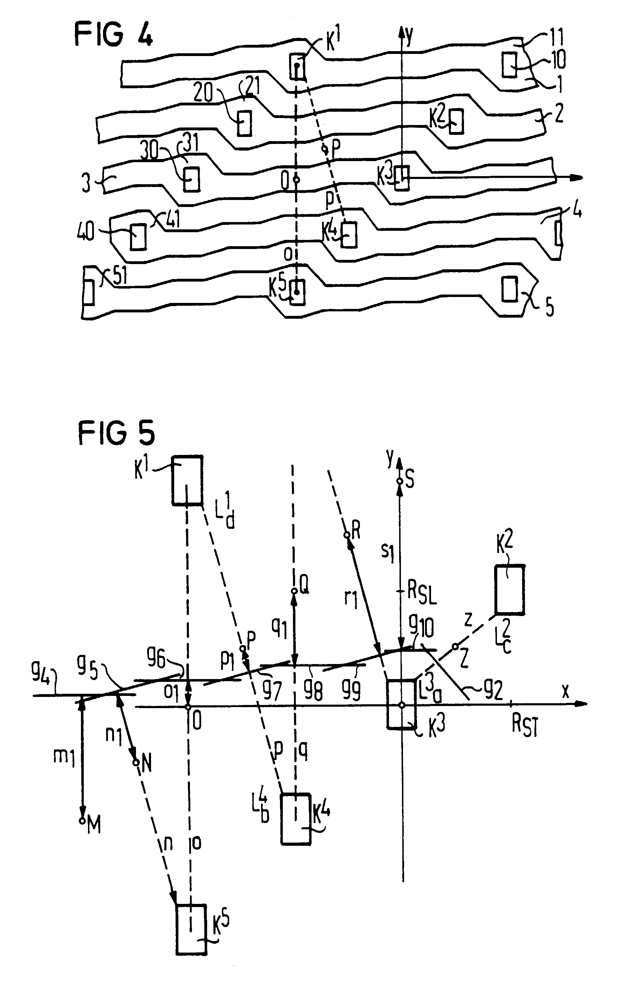

Figur 4: Bei der Ausführungsform gemäß Figur 4 ist die Gerade $g_1$ (und entsprechend $g_3$), die einen Teil der Bitleitungskante beschreibt, durch einen Streckenzug aus vier waagerechten (d.h. in x-Richtung verlaufenden) Geraden $g_4$, $g_6$, $g_8$, $g_{10}$ und drei dazwischenliegenden schrägen Geraden $g_5$, $g_7$, $g_9$ mit einer von 0 verschiedenen Steigung ersetzt (siehe auch Figur 5). Dabei stehen die Geraden $g_4$ - $g_{10}$ senkrecht auf Verbindungsstrecken (m, n, ...s), welche einen Kontakt einer Bitleitung entweder mit dem nächstliegenden Kontakt der (n+1)-ten Bitleitung an ihren Mittelpunkten oder mit dem nächstliegenden Kontakt der n-ten Bitleitung an ihren einander zugewandten Eckpunkten verbinden. Zwar ist die Konstruktion dieser Anordnung etwas aufwendiger, der Vorteil liegt jedoch in einem größeren Überlapp der Kontaktfläche an der Ecke des Kontaktes, sodaß eine größere Dejustierung in dieser Richtung toleriert werden kann.

Figur 5: Die Anordnung läßt sich beispielsweise auf folgende Art konstruieren (am Beispiel der oberen Kante der Bitleitung 3, siehe auch Figur 4):

$g_2$: - wie $g_2$ des ersten Ausführungsbeispiels

$g_6$: - Verbindungsstrecke o zwischen $K^1$ und $K^5$ mit Mittelpunkt 0 (0 läßt sich auch als Mittelpunkt zwischen $K^3$ und dem in -x-Richtung benachbarten Kontakt der Bitleitung 3 konstruieren; Endpunkte der Strecke o jeweils Mittelpunkt der Kontakte)
- $g_6$ ist Senkrechte auf o (also Steigung = 0) im Abstand $0_1 = 1/2 b_B$ von 0. Gleichzeitig mit $g_6$ lassen sich die entsprechenden Abschnitte der Kanten der anderen Bitleitungen konstruieren, die zwischen $K^1$ und $K^5$ ( also in der Umgebung von x = -2 $R_{St}$) ebenfalls die Steigung 0 besitzen und jeweils in Abständen von $b_{Sp}$ beziehungsweise $b_B$ voneinander angeordnet sind.

$g_7$:
- Verbindungsstrecke p zwischen $L^1_d$ und $L^4_b$ mit Mittelpunkt P
- $g_7$ ist Senkrechte zu p im Abstand $1/2 \, b_{Sp}$.

Gleichzeitig mit $g_7$ lassen sich die entsprechenden Abschnitte der Kanten der anderen Bitleitungen konstruieren, die zwischen $L^1_d$ und $L^1_b$ ebenfalls senkrecht zu p sind und jeweils im Abstand von $b_B$ beziehungsweise $b_{Sp}$ voneinander angeordnet sind.

$g_4$, $g_8$ und $g_{10}$:
werden analog zu $g_6$ konstruiert mit Hilfe der Mittelpunkte M, Q und S (die entsprechenden Kontakte liegen teilweise außerhalb des in der Figur 4 dargestellten Ausschnitts). Die Abstände $m_1$, $q_1$, $s_1$ der Geraden von diesen Mittelpunkten betragen, wie aus Figur 4 ersichtlich:

$$m_1 = 1,5 \, b_B + b_{Sp}$$

$$q_1 = 1/2 \, b_B + b_{Sp}$$

$$s_1 = 1,5 \, b_B + 2 \, b_{Sp}$$

$g_5$ und $g_9$:
werden analog zu $g_7$ konstruiert mit Hilfe der Mittelpunkte N und R der nicht vollständig dargestellten Strecken n und r. Die Abstände $n_1$, $r_1$ der Geraden von diesen Mittelpunkten betragen

$$n_1 = b_B + 1/2 \, b_{Sp}$$

$$r_1 = b_B + 1,5 \, b_{Sp}.$$

Ersichtlich hängt die Steigung der Strecken n, p und r von $R_{BL}$, $R_{St}$ und den Ausmaßen der Kontakte in definierter Weise ab, daraus läßt sich die Steigung der auf n, p, r jeweils senkrecht stehenden Geraden $g_5$, $g_7$, $g_9$ analytisch berechnen.

Bei beiden Ausführungsformen lassen sich die Geraden $g_j$, $j = 1, \ldots 10$, sowie ihre Schnittpunkte $S_{jk}$ und damit der genaue Verlauf der Bitleitungskanten mathematisch mit Hilfe der Geradengleichungen $g_j = a_{jx} + b_j$ berechnen. Dies wird im folgenden kurz anhand des 1. Ausführungsbeispiels (siehe Figur 3) und der Figur 6 skizziert:

A) Berechnung der Geraden $g_1$, $g_2$, $g_3$

Für den Winkel $\beta_1$ und damit der Steigung $a_1$ der Geraden $g_1$ folgt unter Verwendung der in der Figur 6 angegebenen Hilfswinkel $\varphi$, $\psi$:

$$\beta_1 = 90° - \varphi - \psi$$

$$a_1 = \operatorname{tg} \beta_1 = (\cot\varphi \, \cot\psi - 1)/(\cot\varphi + \cot\psi)$$

$$\cot\varphi = R_{BL}/R_{St}$$

$$\cot\psi = \operatorname{sqr}(R_{St}^2 + R_{BL}^2 - (b_B + b_{Sp})^2) / (b_B + b_{Sp})$$

$$a_1 = (R_{BL}\operatorname{sqr}(R_{BL}^2 + R_{St}^2 - (b_B + b_{Sp})^2) - R_{St}(b_B + b_{Sp}))/$$

$$(R_{St}\operatorname{sqr}(R_{BL}^2 + R_{St}^2 - (b_B + b_{Sp})^2) + R_{BL}(b_B + b_{Sp}))$$

Den Achsabschnitt $b_1$ der Geraden $g_1$ findet man aus der Bedingung, daß $g_1$ einen Abstand $b_B/2$ von 0 hat, also durch den Punkt

$$(-2R_{St} - b_B/2 \sin \beta_1; \; b_B/2 \cos \beta_1)$$

oder

$$(-2R_{St} - b_B a_1/(2sqr(1+a_1^2)); \; b_B/(2sqr(1+a_1^2)))$$

geht. Also ist

$$b_1 = b_B/(2sqr(1+a_1^2)) + 2a_1 R_{St} + b_b a_1^2/(2sqr(1+a_1^2)).$$

Die Gerade $g_3$ entsteht aus $g_1$ durch Translation um $4R_{St}$ in x-Richtung. Damit werden die Kenngrößen von $g_3$:y $= a_3 x + b_3$

$$a_3 = a_1$$

$$b_3 = b_1 - 4 R_{St} a_1.$$

Für $g_2$: $y = a_2 x + b_2$ findet man

$$a_2 = -(R_{St} - x_{KL})/(R_{BL} - Y_{KL})$$

wobei $x_{KL}$ die Abmessung des Kontakt lochs in x-Richtung und $y_{KL}$ die in y-Richtung ist. $g_2$ geht durch den Punkt.

$$(R_{St}/2 + b_{Sp}/2 \sin \beta_2; \; R_{BL}/2 - b_{Sp}/2 \cos \beta_2)$$

oder

$$(R_{St}/2 + b_{Sp} a_2/(2sqr(1+a_2^2); \; R_{BL}/2 - b_{Sp}/(2sqr(1+a_2^2)))$$

(mit $\beta_2$ dem Steigunswinkel von $g_2$).
Damit wird

$$b_2 = R_{BL}/2 - b_{Sp}/(2sqr(1+a_2^2)) - R_{St} a_2/2 -$$

$$-b_{Sp} a_2^2/(2sqr(1+a_2^2)).$$

B) Berechnung der Schnittpunkte $S_{12}$ und $S_{23}$:

$$S_{12}:(-(b_2-b_1)/(a_2-a_1), \; -a_2(b_2-b_1)/(a_2-a_1) + b_2)$$

und

$$S_{23}:(-(b_3-b_2)/(a_3-a_2), \; -a_3(b_3-b_2)/(a_3-a_2) + b_3).$$

Mit analogen Überlegungen lassen sich die Geraden $g_4$ - $g_{10}$ des 2. Ausführungsbeispiels berechnen. Wie bereits erläutert, besitzt es den Vorteil, daß der Überlapp an den Ecken des Kontaktes noch etwas größer ist. Der Überlapp beträgt an der Ecke

$$L_a: 0,5\text{sqr}((R_{St}-x_{KL})^2 + (R_{BL}-y_{KL})^2) - b_{Sp},$$

$$L_d: 0,5\text{sqr}((R_{St}-x_{KL})^2 + (3R_{BL}-y_{KL})^2) - 2b_b - 3b_{Sp}.$$

**Patentansprüche**

1.  Bitleitungsanordnung für integrierte Schaltungen, wobei

    -   jede Bitleitung (1 - 5) mindestens einen Kontakt (10, 20, 30, 40, 50) zu mindestens einem unterliegenden leitfähigen Gebiet besitzt.
    -   nur in einer Umgebung des Kontaktes zu einer Kontaktfläche (11, 21, 31, 41, 51) verbreitert ist,
    -   die Kontakte benachbarter Bitleitungen versetzt unter Bildung einer mindestens 3-fachen Staffelung angeordnet sind,

    **dadurch gekennzeichnet**,
    daß der Abstand ($b_{Sp}$) zwischen den Kanten zweier benachbarter Bitleitungen im Rahmen von Herstelltoleranzen überall gleich groß ist.

2.  Bitleitungsanordnung nach Anspruch 1,
    **dadurch gekennzeichnet**,
    daß jede Bitleitung (1 - 5) eine in einer ersten Richtung aufeinanderfolgende Reihe von Kontakten aufweist, wobei jeder Kontakt das leitfähige Gebiet mindestens einer Zelle kontaktiert.

3.  Bitleitungsanordnung nach Anspruch 2,
    **dadurch gekennzeichnet**,
    daß bei vorgegebener geometrischer Anordnung und Größe der Kontakte (10, 20, 30, 40, 50) die Bitleitungskanten abschnittsweise Geraden ($g_1$, $g_2$, $g_3$) darstellen, die zwei mindestens im Vorzeichen unterschiedliche und bezüglich der ersten Richtung von Null verschiedene Steigungen besitzen.

4.  Bitleitungsanordnung nach einem der Ansprüche 1 - 2,
    **dadurch gekennzeichnet**,
    daß bei vorgegebender geometrischer Anordnung und Größe der Kontakte (10, 20, 30, 40, 50) die Bitleitungskanten abschnittsweise Geraden ($g_2$, $g_4$ - $g_{10}$) darstellen, die mindestens drei verschiedene Steigungen besitzen.

**Claims**

1.  Bit line arrangement for integrated circuits, it being the case that

    -   each bit line (1 - 5) has at least one contact (10, 20, 30, 40, 50) to at least one underlying conductive region,
    -   and is widened to form a contact surface (11, 21, 31, 41, 51) only in an environment of the contact,
    -   the contacts of adjacent bit lines are arranged so as to be offset, forming an at least 3-fold stagger,

    characterised in that the distance ($b_{Sp}$) between the edges of two adjacent bit lines is everywhere the same within the range of manufacturing tolerances.

2.  Bit line arrangement according to Claim 1, characterised in that each bit line (1 - 5) has a row of contacts succeeding one another in a first direction, each contact contacting the conductive region of at least one cell.

3.  Bit line arrangement according to Claim 2, characterised in that, given a prescribed geometrical arrangement and size of the contacts (10, 20, 30, 40, 50), the bit line edges represent, in segments, straight lines ($g_1$, $g_2$, $g_3$) which

have two gradients which differ at least in sign and differ from zero with respect to the first direction.

4. Bit line arrangement according to one of Claims 1-2, characterised in that given a prescribed geometrical arrangement and size of the contacts (10, 20; 30, 40, 50), the bit line edges represent, in segments, straight lines ($g_2$, $g_4$ - $g_{10}$) which have at least three different gradients.

**Revendications**

1. Disposition de conducteurs de bit pour circuits intégrés,

   - chaque conducteur de bit (1 à 5) comprenant au moins un contact (10, 20, 30, 40, 50) vers au moins une région conductrice sous-jacente,
   - chaque conducteur de bit n'étant élargi qu'au voisinage du contact en une surface de contact (11, 21,31, 41, 51),
   - les contacts de conducteurs de bit voisins sont disposés en étant décalés et en formant un pas d'au moins trois,

     caractérisée en ce que
     l'écart ($b_{Sp}$) entre les bords de deux conducteurs de bit voisins est le même partout dans le cadre des tolérances de fabrication.

2. Disposition de conducteurs de bit suivant la revendication 1,
     caractérisée en ce que
     chaque conducteur de bit (1 à 5) comporte une rangée de contacts se suivant dans une première direction, chaque contact étant en contact avec la région conductrice d'au moins une cellule.

3. Disposition de conducteurs de bit suivant la revendication 2,
     caractérisée en ce que
     pour une dimension et une taille géométrique prescrites des contacts (10, 20, 30, 40, 50), les bords des conducteurs de bit représentent des segments de droite ($g_1$, $g_2$, $g_3$), qui ont deux pentes au moins de signes différents et différentes de 0 par rapport à la première direction.

4. Disposition de conducteurs de bit suivant l'une des revendications 1 et 2,
     caractérisée en ce que
     pour une disposition et une taille géométrique prescrite des contacts (10, 20, 30, 40, 50), les bords des conducteurs de bit représentent des segments de droites ($g_2$, $g_4$ à $g_{10}$) qui ont au moins trois pentes différentes.

FIG 1

FIG 6

# FIG 2

# FIG 3

# FIG 4

# FIG 5